# EUROPÄISCHE PATENTSCHRIFT

(11) **EP 0 385 158 B1**
(45) Veröffentlichungstag und Bekanntmachung des Hinweises auf die Patenterteilung: **29.11.1995**
(21) Anmeldenummer: 90102628.6
(22) Anmeldetag: 10.02.1990
(51) Int. Cl.: H03K 5/153, G01S 13/78

(54) **Impulsabstandsdecodierung**
Pulse spacing decoding
Décodage d'intervalle d'impulsions

(30) Priorität: 03.03.1989 DE 3906706
(43) Veröffentlichungstag der Anmeldung: 05.09.1990
(73) Patentinhaber: Alcatel SEL Aktiengesellschaft, D-70435 Stuttgart (DE)
(72) Erfinder: Gutekunst, Jürgen, D-7440 Nürtingen (DE)
(74) Vertreter: Graf, Georg Hugo, Dipl.-Ing.

(56) Entgegenhaltungen:
- DE-B- 1 762 007
- DE-B- 2 350 198
- FR-A- 2 549 967
- GB-A- 1 158 759
- PATENT ABSTRACTS OF JAPAN Band 5, Nr. 70 (E-56)(742), 12. Mai 1981 & JP-A-5619226

## Beschreibung

Die Erfindung betrifft eine Schaltungsanordnung zur Impulsabstandscodierung gemäß dem Oberbegriff des Anspruchs 1.

Im Luftverkehr werden zur bordseitigen Bestimmung der Entfernung eines Flugzeuges von einer Bodenstation Entfernungsmeßgeräte verwendet, die die Laufzeiten von bordseitig ausgesendeten Abfragesignalen und von der Bodenstation daraufhin abgegebenen, in der Bordstation empfangenen Antwortsignalen auswerten. Die Antwortsignale bestehen dabei jeweils aus mehreren, insbesondere aus zwei Einzelimpulsen, die einen fest vorgegebenen zeitlichen Abstand voneinander haben, der für die abgefragte Bodenstation charakteristisch ist und bordseitig dazu benutzt wird, die von der abgefragten Bodenstation ausgesendeten Antwortsignale von denen anderer Bodenstationen und von anderweitigen Störsignalen zu unterscheiden.

Eine Schaltungsanordnung gemäß dem Oberbegriff des Patentanspruchs 1 ist z.B. in der DE-B 2350 198 beschrieben. Als Verzögerungsschaltungen werden hier Schieberegister verwendet, die von einem schnellen Taktgeber getaktet werden und ein empfangenes Antwortsignal über eine vorgegebene Anzahl von Takten hinweg, für eine dem zeitlichen Abstand der Einzelimpulse des Antwortsignals entsprechende Zeit verzögern. Eine Und-Schaltung als Koinzidenzglied stellt fest, ob nach Ablauf der vorgegebenen Verzögerungszeit das in der auszulesenden Stufe des Schieberegisters enthaltene Signal mit dem am Schieberegistereingang anstehenden Signal übereinstimmt.

Die bekannte Schaltung enthält mehrere Schieberegister. Diese müssen, wenn eine hohe Genauigkeit der Impulsabstandsmessung erreicht werden soll, viele Stufen enthalten. Der bordseitige Empfänger wird damit aufwendig und infolge der Vielzahl der Bauelemente störungsanfällig.

Die Aufgabe der Erfindung besteht daher darin, eine Schaltungsanordnung zu schaffen, die eine genaue Überprüfung von Impulsabständen mit möglichst wenig Schaltungsaufwand ermöglicht. Diese Aufgabe wird durch die im Anspruch 1 angegebenen Merkmale gelöst.

Die durch die Erfindung erzielten Vorteile bestehen insbesondere darin, daß durch die Verwendung eines Schreib-/Lesespeichers mit wahlfreiem Zugriff mit einer üblicherweise hohen Anzahl Speicherzellen eine optimale Auflösung und damit eine sehr genaue Überprüfung der Impulsabstände möglich ist.

Vorteilhafte Ausgestaltungen der Schaltungsanordnung nach der Erfindung sind in den Unteransprüchen angegeben.

Anhand zweier Anwendungsbeispiele wird die Erfindung in Verbindung mit den Zeichnungen nachfolgend näher erläutert. Es zeigen:
- Fig. 1: das Blockschaltbild einer Schaltungsanordnung gemäß der Erfindung,
- Fig. 2: das Impulsdiagramm zu einem ersten Anwendungsbeispiel,
- Fig. 3: das Impulsdiagramm zu einem zweiten Anwendungsbeispiel.

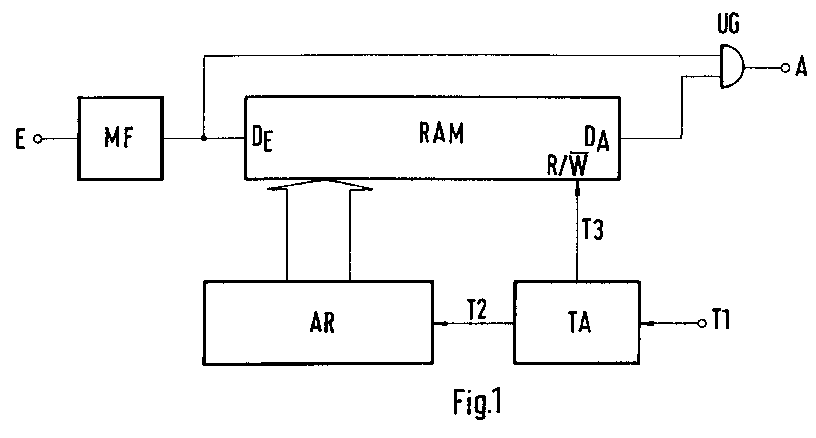

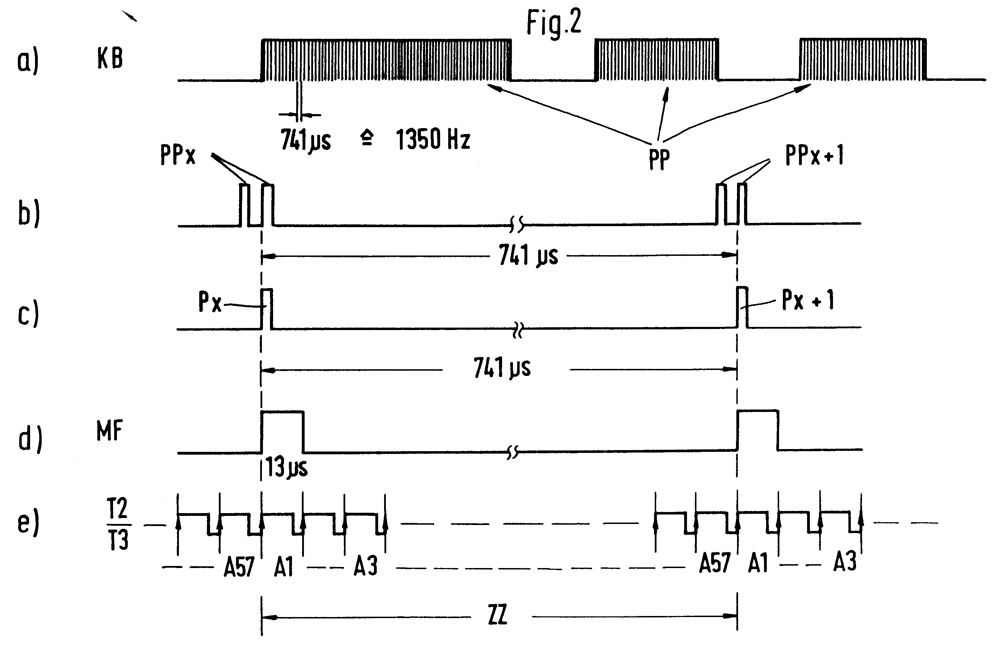

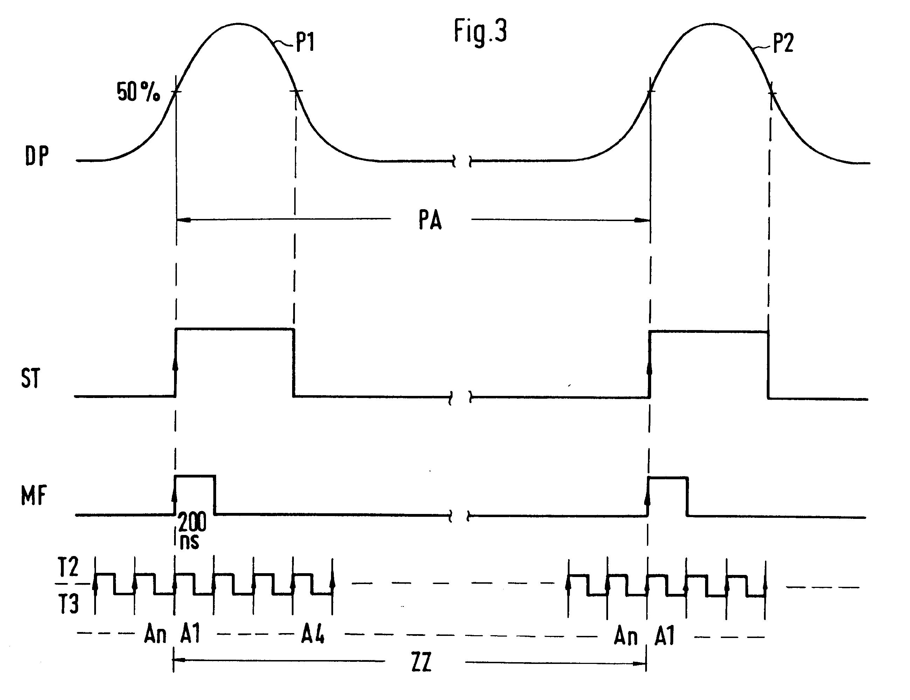

Fig. 1 zeigt das Blockschaltbild einer Anordnung zur Impulsabstandscodierung. Sie besteht aus der Reihenschaltung eines Monoflop MF mit einem Schreib-/Lesespeicher mit wahlfreiem Zugriff RAM, einem UND-Glied UG, dessen zwei Eingänge mit dem Eingang D_{E} bzw. dem Ausgang D_{A} des Schreib-/Lesespeichers RAM verbunden sind, einem Adresszählregister AR zum Schreib-/Lesespeicher RAM, einer Taktaufbereitung TA und einem nicht dargestellten, einen Grundtakt T1 liefernden Geber. Die Taktaufbereitung TA leitet aus dem Grundtakt T1 einen Zähltakt T2 ab, durch den das Adresszählregister AR fortgeschaltet wird. Die Länge des Zählzyklus ZZ (Fig. 2 und 3) läßt sich auf den einzelnen Anwendungsfall einstellen. Ein Lese-/Schreib-Eingang R/W des Schreib-/Lesespeichers RAM ist mit einem Lese-/Schreib-Takt T3 belegt, der durch die Taktaufbereitung TA synchron zum Zähltakt T2 erzeugt wird. In der zweiten Hälfte jedes T3-Taktes wird durch Polaritätswechsel der Ansteuerung des Eingangs R/W bewirkt, daß in die momentan adressierte Speicherzelle, deren Inhalt zuvor über den Ausgang D_{A} ausgelesen worden ist, das am Eingang D_{E} des Schreib-/Lesespeichers RAM anstehende aktuelle Signal eingeschrieben wird. Während des Teiltaktes "Lesen" stehen das aktuelle Signal und das während des vorhergehenden Zählzyklus ZZ (Fig. 2 und 3) in der nun wieder adressierten Speicherzelle abgelegte Signal am UND-Glied UG an. Liegt an beiden Eingängen des UND-Gliedes 1-Potential an, so schaltet das UND-Glied durch. Die Potentialänderung am Ausgang A zeigt an, daß zwei Impulse im vorgegebenen zeitlichen Abstand erkannt wurden. Der dem Schreib-/Lesespeicher RAM vorgeschaltete Monoflop MF dient als Impulsformer. Seine Standzeit ist gleich der Taktzeit des Zähltaktes T2.

Fig. 2 zeigt das Impulsdiagramm bei der Anwendung der Schaltungsanordnung gemäß Fig. 1 zum Erkennen der Kennung KB einer Bodenstation im DME-System. Die Kennung KB besteht aus einem 3-Buchstaben-Morsecode (nur teilweise dargestellt) (Fig. 2a). Die Impulse des Morsecodes sind aus einer Vielzahl von periodischen Impulspaaren PP mit der Folgefrequenz von 1350 Hz gebildet (Fig. 2b). Die im Abstand von 40 ms abgestrahlte Kennung KB ist in ein aus dem Senderrauschen abgeleitetes, aus statistisch verteilten Impulsen bestehendes Gemisch eingelagert. Über das Kriterium der im 1350Hz-Takt aufeinanderfolgenden Impulspaare PP (Fig. 2b) kann die Kennung KB mit Hilfe der Schaltungsanordnung gemäß Fig. 1 aus dem Impulsgemisch herausgefiltert werden.

Die in der eingangs beschriebenen Weise decodierten Impulse gelangen auf den Eingang E der Schaltung gemäß Fig. 1. Sie werden im Monoflop MF aufbereitet, dessen Standzeit gleich dem Zähltakt T2 ist; im vorliegenden Fall 13 us (Fig. 2d). Der Zählzyklus ZZ des Adresszählregisters AR entspricht dem zu erkennenden Impulsabstand. Nur Impulse, deren Abstand diesem Zyklus ZZ entsprechen, werden als solche erkannt. Damit wirkt die Schaltung gemäß Fig. 1 wie ein extrem steiles Filter.

Fig. 2c zeigt zwei periodische Impulse Px und Px+1, die durch Decodierung aus den Impulspaaren PPx und PPx+1 (Fig. 2b) abgeleitet sind und entsprechend der Folgefrequenz von 1350 Hz einen zeitlichen Abstand von 741 us haben. Auf diesen Abstand ist der Zählzyklus ZZ mit siebenundfünfzig Zähltakten T2 von jeweils 13 us eingestellt. Wie bereits erwähnt, wird jeder am Eingang E auftretende Impuls gemäß Fig. 2d durch den Monoflop MF auf die eingestellte Dauer von 13 us gebracht. Dieses ist notwendig, um bei der nachfolgenden Bearbeitung stets gleiche Verhältnisse zu haben. Da zwischen den eintreffenden Impulsen und dem Zähltakt T2 kein Synchronismus besteht, wird die aus Einfachkeitsgründen in Fig. 2 dargestellte zeitliche Übereinstimmung zwischen den MF-Impulsen und der Adressierung einer Speicherzelle in seltenen Fällen auftreten. Es ist jedoch unerheblich, ob der Zähltakt T2 gegenüber dem jeweiligen MF-Impuls vor- oder nacheilt, da die im Zyklusabstand ZZ folgenden Impulse unter den gleichen Gegebenheiten abgetastet werden und daher das gleiche Erscheinungsbild haben. Genauso unerheblich ist es, in welcher Speicherzelle A1 bis A57 des Schreib-/Lesespeichers RAM ein Impulszustand abgelegt worden ist, da der Zyklus ZZ der gleiche bleibt und damit ein im vorgegebenen Zyklusabstand auftretender Impuls in dem Augenblick zur Auswertung ansteht, zu dem die entsprechende Speicherzelle wieder adressiert ist. Die Fig. 2c bis 2e veranschaulichen dieses. Der erste periodische Impuls Px wird durch den Monoflop MF in einen Impuls umgeformt, der für 13 us am Eingang D_{E} des Schreib-/Lesespeichers RAM ansteht. Während dieser Zeit erfolgt das Auslesen der jeweils adressierten Speicherzelle, hier A1. Die Speicherzelle A1 sei leer, so daß die UND-Bedingung für UG nicht erfüllt ist. Im letzten Drittel der Taktzeit T2 wird über den Potentialwechsel des Lese-/Schreibtaktes T3 der aktuelle Signalzustand am Eingang D_{E} in die Speicherzelle A1 eingeschrieben. Mit Beginn des folgenden Zählzyklus ZZ steht der nächste periodische Impuls Px+1 an; gleichzeitig ist wieder die Speicherzelle A1 adressiert. Deren Inhalt ist nunmehr gleich dem am Eingang D_{E} anstehenden Potential, so daß nunmehr die UND-Bedingung für UG erfüllt ist. Während des folgenden Teiltaktes "Schreiben" wird wiederum der aktuelle Signalzustand in die Speicherzelle A1 eingeschrieben. Damit ist Sichergestellt, daß Impulse mit schon geringfügig anderen Abständen unterdrückt werden. Im Rahmen der Kapazität des Schreib-/Lesespeichers RAM kann die Auflösung bei Bedarf in weiten Grenzen geändert werden.

Fig. 3 zeigt das Impulsdiagramm bei der Anwendung der Schaltungsanordnung gemäß Fig. 1 zum Erkennen des Abstandes PA zwischen den Einzelimpulsen P1 und P2 eines Doppelimpulses DP der eingangs genannten Art.

Der empfangene Doppelimpuls DP wird durch einen 50%-Schmidt-Trigger ST digitalisiert und anschließend auf den Eingang E der Schaltungsanordnung gemäß Fig. 1 gegeben. Wie im vorhergehenden Beispiel erfolgt eine Impulsumformung durch den Monoflop MF. Bei einem beispielsweisen Zähltakt von 5 MHz beträgt die Taktzeit und damit auch die Standzeit des Monoflops MF 200 ns. Der Zählzyklus ZZ des Adresszählregisters AR entspricht auch hier dem zu erkennenden Impulsabstand PA. In wesentlicher Übereinstimmung mit dem zuvor Beschriebenen läuft der zyklische Lese-/Schreibvorgang der nacheinander adressierten Speicherzellen A1 bis An ab. Auch hier tritt am Ausgang A der Schaltungsanordnung gemäß Fig. 1 ein Signal auf, wenn im Abstand des Zählzyklus ZZ die adressierte Speicherzelle und das Signal am Eingang D_{E} des Schreib-/Lesespeichers RAM 1-Potential aufweisen. Durch die sehr hohe Auflösung von 200 ns ist sichergestellt, daß Doppelimpulse mit einem um mehr als 200 ns differierenden zeitlichen Folgeabstand mit Sicherheit ausgeschieden werden.

## Patentansprüche

1. Schaltungsanordnung zur Impulsabstandsdecodierung in Entfernungsmeßeinrichtungen, die sich an Bord von Luftfahrzeugen befinden und Abfragesignale an Bodenstationen senden und jeweils die vom Aussendezeitpunkt eines Abfragesignales bis zum Empfang eines auf das Abfragesignal hin von einer Bodenstation rückgesendeten, aus mindestens zwei in vorgegebenem zeitlichem Abstand nacheinander ausgesendeten Einzelimpulsen bestehenden Antwortsignales vergangene Zeit, sowie zusätzlich den für die jeweilige Bodenstation charakteristischen zeitlichen Abstand der nacheinander ausgesendeten Einzelimpulse des Antwortsignales voneinander messen, und die hierzu mindestens einen Taktgeber, eine von diesem gesteuerte Verzögerungsschaltung und ein Koinzidenzglied aufweist, an dessen Ausgang eine Potentialänderung auftritt, wenn die von der Verzögerungsschaltung bewirkte Verzögerung gleich dem vorgegebenen zeitlichen Abstand der nacheinander ausgesendeten Einzelimpulse eines Antwortsignales ist, **dadurch gekennzeichnet**, daß als Verzögerungsschaltung ein Schreib-/Lesespeicher (RAM) mit wahlfreiem Zugriff und ein diesem zugeordnetes, mit einem ersten, aus einem Grundtakt (T1) gewonnenen Takt (T2) fortgeschaltetes Adreßzählregister vorgesehen sind, daß dem Schreib-/Lesespeicher ein Impulsformer zur Erzeugung von Impulsen vorgegebener Dauer aus einem durch Decodierung eines Antwortsignales gewonnenen Eingangssignal vorgeschaltet ist, daß die so erzeugten Impulse sowohl am Eingang des Schreib-/Lesespeichers als auch an einem Eingang des Koinzidenzgliedes anstehen, daß eine Taktaufbereitung (TA) vorgesehen ist, die aus dem Grundtakt (T1) einen zweiten Takt (T3) erzeugt, mit dem der Schreib-/Lesespeicher ausgelesen und überschrieben wird, und dessen Periode dem vorgegebenen zeitlichen Abstand der beiden Einzelimpulse des Antwortsignales entspricht, und daß während jeder Periode des zweiten Taktes eine gerade adressierte Zelle des Schreib-/Lesespeichers ausgelesen und mit dem am Eingang des Schreib-/Lesespeichers anliegenden Signal überschrieben wird, und daß das ausgelesene Signal einem zweiten Eingang der Koinzidenzschaltung zugeführt wird.

2. Schaltungsanordnung nach Anspruch 1, dadurch gekennzeichnet, daß der Impulsformer von einem monostabilen Kippglied (MF) gebildet wird.

3. Schaltungsanordnung nach einem der vorstehenden Ansprüche, dadurch gekennzeichnet, daß der Zählzyklus (ZZ) des Adreßzählregisters (AR) einstellbar ist.

## Claims

1. A circuit arrangement for decoding pulse spacings in distance-measuring equipment which is located aboard aircraft and which transmits interrogation signals to ground stations and measures the elapsed time between the transmission of an interrogation signal and the reception of a reply signal transmitted by the ground station in response to the interrogation signal and consisting of at least two consecutively transmitted single pulses separated by a predetermined time interval, and, in addition, the time interval between the consecutively transmitted single pulses of the reply signal, which is characteristic of the respective ground station, said circuit arrangement comprising at least one clock generator, a delay circuit controlled by the clock generator, and a coincidence gate at whose output occurs a change of protential when the delay introduced by the delay circuit is equal to the predetermined time interval between the consecutively transmitted single pulses of a reply signal, **characterized in** that as the delay circuit, a random-access memory (RAM) and an address counter register associated therewith and incremented at the pulse repetition rate of a first clock signal (T2) derived from a basic clock signal (T1) are provided, that the random-access memory is preceded by a pulse shaper for generating pulses of a predetermined duration from an input signal derived by decoding a reply signal, that the pulses thus generated are applied both to the input of the random-access memory and to one input of the coincidence gate, that a clock conditioner (TA) is provided which derives from the basic clock signal (T1) a second clock signal (T3) with which the contents of the random-access memory are read out and overwritten and whose period is equal to the predetermined time interval between the two single pulses of the reply signal, and that during each period of the second clock signal, the content of a currently addressed cell of the random-access memory is read out and is overwritten with the signal applied at the input of the random-access memory, and that the signal read out is applied to a second input of the coincidence gate.

2. A circuit arrangement as claimed in claim 1, characterized in that the pulse shaper is a monostable multivibrator (MF).

3. A circuit arrangement as claimed in either of the preceding claims, characterized in that the count cycle (ZZ) of the address counter register (AR) is adjustable.

## Revendications

1. Dispositif de circuit pour le décodage de l'intervalle de temps d'impulsions dans des dispositifs de mesure de distance qui se trouvent à bord d'aéronefs et envoient des signaux d'interrogation aux stations au sol et mesurent chaque fois le temps passé, depuis l'instant de l'émission d'un signal d'interrogation, jusqu'à la réception d'un signal de réponse renvoyé par une station au sol à la suite du signal d'interrogation et constitué d'au moins deux impulsions individuelles émises successivement dans un intervalle de temps prescrit, ainsi qu'en outre l'intervalle de temps, caractéristique pour chacune des stations au sol, entre les impulsions individuelles du signal de réponse émises successivement, et qui présente dans ce but au moins un émetteur de signal d'horloge, un circuit de retard commandé par celui-ci et un élément de coïncidence à la sortie duquel se produit une modification de potentiel lorsque le retard opéré par le circuit de retard est égal à l'intervalle de temps prescrit des impulsions individuelles émises successivement, caractérisé par le fait que comme circuit de retard sont prévus une mémoire d'écriture/lecture (RAM) à accès sélectif et un registre de comptage d'adresses qui lui correspond et qui est activé par un premier signal d'horloge (T2) obtenu à partir d'un signal d'horloge de base (T1), qu'en amont de la mémoire d'écriture/lecture est mis en circuit un organe de mise en forme d'impulsion pour produire des impulsions de durée prescrite à partir d'un signal d'entrée obtenu par décodage d'un signal reçu en réponse, que les impulsions ainsi obtenues arrivent aussi bien à l'entrée de la mémoire d'écriture/lecture qu'à une entrée de l'élément de coïncidence, qu'il est prévu un traitement de signal d'horloge (TA) qui, à partir du signal d'horloge de base (T1), produit un second signal d'horloge (T3) avec lequel il y a lecture dans la mémoire d'écriture/lecture puis écriture par surcharge dans cette mémoire, et dont la période correspond à l'intervalle de temps prescrit des deux impulsions individuelles du signal de réponse, et que pendant chaque période du deuxième signal d'horloge il y a, dans une cellule de la mémoire d'écriture/lecture à laquelle on accède justement, lecture puis écriture par surcharge par le signal qui se trouve à l'entrée de la mémoire d'écriture/lecture, et que le signal lu est envoyé à une seconde entrée du circuit de coïncidence.

2. Dispositif de circuit selon la revendication 1, caractérisé par le fait que l'organe de mise en forme d'impulsion est formé par une bascule monostable (MF).

3. Dispositif de circuit selon l'une des revendications précédentes, caractérisé par le fait que le cycle de comptage (ZZ) du registre (AR) de comptage d'adresses est réglable.
